# EUROPÄISCHE PATENTSCHRIFT

(11) **EP 1 126 521 B1**
(45) Veröffentlichungstag und Bekanntmachung des Hinweises auf die Patenterteilung: **21.05.2003**
(21) Anmeldenummer: 00102944.6
(22) Anmeldetag: 14.02.2000
(51) Int. Cl.: H01L 23/498, H01L 23/495, H01L 21/48, H01R 43/20

(54) **Verfahren zur Herstellung elektrischer Kontakte eines elektrischen Bauelements**
Method of manufacturing electrical contacts of an elelctrical device
Méthode de fabrication des contacts électriques d'un dispositif électrique

(43) Veröffentlichungstag der Anmeldung: 22.08.2001
(73) Patentinhaber: AB Mikroelektronik Gesellschaft m.b.H., 5020 Salzburg (AT)
(72) Erfinder: Wilczek, Klaus-Peter, 83404 Ainring (DE)
(74) Vertreter: Hofinger, Engelbert, Dr.Dr.

(56) Entgegenhaltungen:
- DE-U- 29 712 470
- GB-A- 2 309 834
- US-A- 4 214 120
- US-A- 4 547 964
- US-A- 5 060 117

## Beschreibung

Die Erfindung bezieht sich auf ein Verfahren zur Herstellung eines mehrere rechtwinkelig abstehende, aufgelötete Steckkontakte aufweisenden elektrischen Bauelementes, insbesondere eines auf einer Keramikplatte angeordneten Halbleiterelementes.

Insbesondere im Automobilbau kommen derzeit elektromechanische Schalter in großer Zahl zum Einsatz. Die Verwendung elektronischer Bauteile statt dieser Relais liegt aufgrund der großen Leistungsfähigkeit und geringeren Störanfälligkeit nahe. Die kostengünstige Herstellung solcher elektronischer Schalter ist jedoch noch mit einer Reihe von Problemen verbunden. Eines davon besteht darin, daß die elektrischen Anschlüsse durch Steckkontakte genau definierter Form und Anordnung vermittelt werden müssen.

Wird ein elektronisches Schaltelement in Hybridbauweise aus einer bedruckten Keramikplatte mit aufgesetzten Leistungstransistoren ausgebildet, so ist es ausgesprochen schwierig, die normgemäßen Steckkontakte so aufzulöten, daß die vier Leitflächen koplanar sind und das Steckerbild innerhalb des Toleranzbereiches bleibt. Zur Lösung dieses Problems kann man die Steckkontakte in eine Graphitform einfädeln, welche die Stecker beim Löten in Position hält. Dieser Vorgang ist jedoch kaum automatisierbar und daher sehr aufwendig. Möglich wäre es auch, die Stecker mit einem Halterahmen aus Kunststoff zu umspritzen, welcher im System verbleibt. Hier ist, abgesehen von den Kosten, das nachträgliche Vergießen der Spritzteile in Hinblick auf die Materialverträglichkeit problematisch.

In US 4 214 120 A und GB 2 309 834 A werden Steckkontakte, die zunächst durch eine Randleiste verbunden sind auf ein Substrat gelötet und die Randleiste anschließend entfernt. Die Steck-kontakte werden um eine zu den Steckkontakten senkrechte Achse gebogen.

Die Erfindung löst das Problem durch ein Verfahren gemäß Anspruch 1.

Besonders hoch wird die erreichte Präzision, wenn die Steckkontakte bis nach Beendigung des Lötvorganges zusätzlich durch einen mit Abstand von ihren abgewinkelten Enden verlaufenden Steg verbunden bleiben, welcher zusammen mit den Steckkontakte hergestellt ist, wobei zunächst die Enden des Steges durch eine Rastverbindung miteinander verbunden werden.

Weitere Einzelheiten der Erfindung werden anschließend anhand der Zeichnung beispielhaft erläutert. In dieser stellt
Fig. 1 schematisch die wesentlichen Teile des herzustellenden Bauelementes dar,
Fig. 2 ein einfaches Beispiel für die Durchführung des erfindungsgemäßen Verfahrens;
Fig. 3 ist eine praxisnahe Darstellung eines aufzubringenden Flachsteckers,
Fig. 4 zeigt die Herstellung mehrerer Stecker nach Fig. 3 aus einem Blechband.
Fig. 5 ist ein Schnitt nach der Linie V-V in Fig. 4.

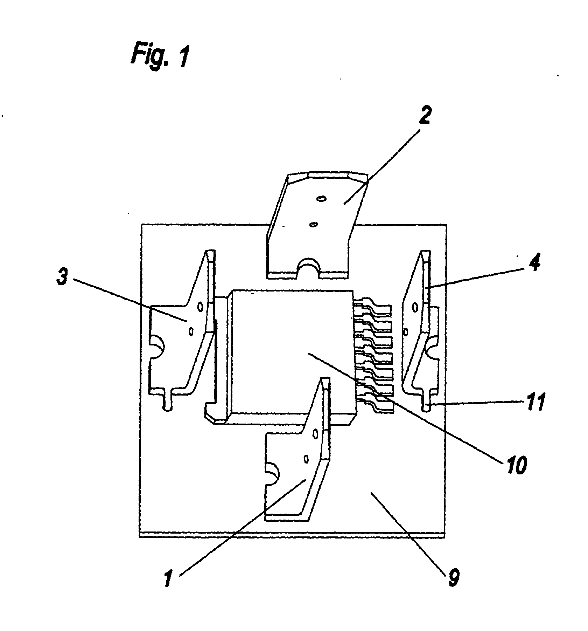

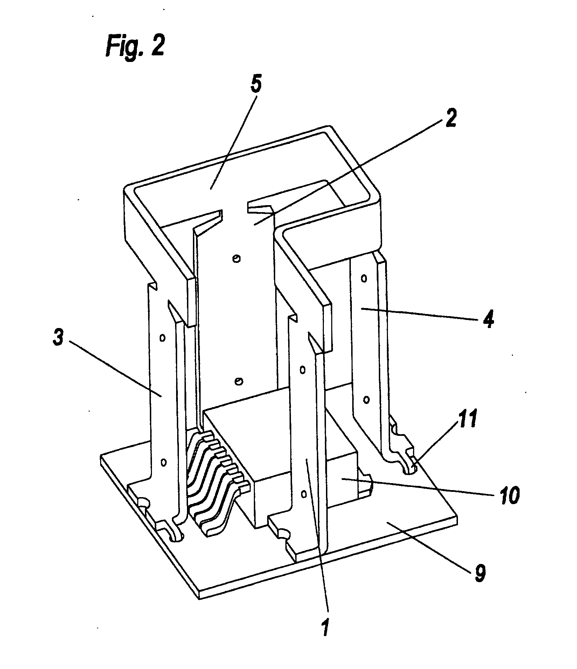

Das erfindungsgemäß herzustellende elektronische Bauelement besteht aus einer Unterlage 9 in Form einer Keramikplatte, auf welcher einerseits eine Schaltung aufgedruckt und andererseits ein Transistorelement 10 angeordnet ist. Steckkontakte in Form genormter Flachstecker 1 - 4 aus Blech sollen präzise auf die Unterlage 9 aufgelötet werden. Hiezu ist erfindungsgemäß vorgesehen, daß die Flachstecker 1 - 4 aus einem Blechband ausgestanzt werden, von welchem während des Lötvorganges noch eine Randleiste 5 erhalten bleibt, welche die Flachstecker 1 - 4 verbindet und dabei in ihrer gegenseitigen Position hält. Die Stellung relativ zur Unterlage 9 kann durch Justierfahnen 11 gesichert sein, welche in korrespondierende Ausnehmungen der Unterlage 9 eingreifen. Diese Situation ist in Fig. 2 dargestellt. Nach dem Verlöten wird die Randleiste 5 entfernt, sodaß sich die Situation nach Fig. 1 ergibt, welche das fertige Bauelement darstellt. Dieses kann allerdings noch mit einer Vergußmasse überdeckt werden, aus welcher die Enden der Flachstecker 1 - 4 vorstehen.

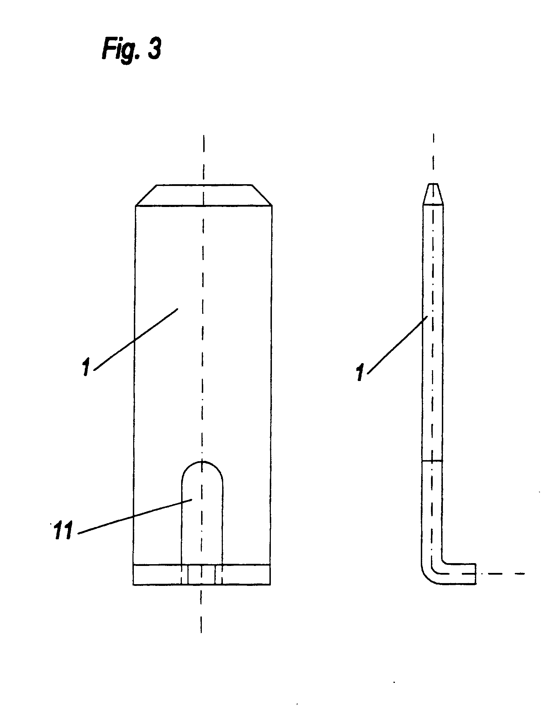

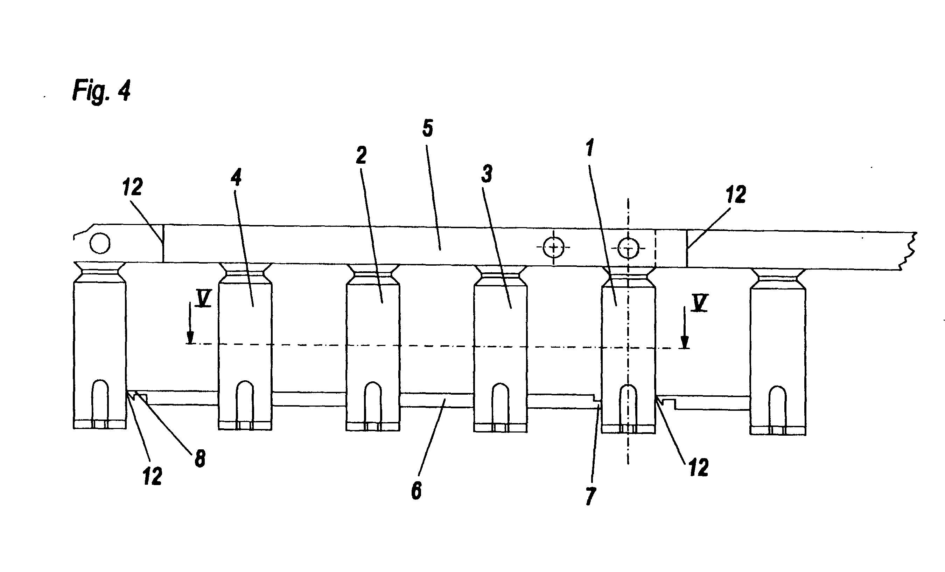

Der bisher schematisch beschriebene Herstellungsvorgang ist in Fig. 3 - 5 etwas praxisnäher dargestellt. So ist in Fig. 3 gezeigt, daß der an seinem unteren Ende abgewinkelte Flachstecker 1 ein Langloch 11 aufweist, welches seinen Halt in der in Fig. 1 nicht dargestellten Vergußmasse verbessert. Fig. 4 zeigt, wie Flachstecker 1 - 4 fortlaufend aus einem Blechband durch Stanzen und Abbiegen hergestellt werden. Nach Ablängen des Blechbandes entlang der Schnittlinien 12 bleiben die später freien Enden der Flachstecker 1 - 4 durch eine Randleiste 5 verbunden. Eine zusätzliche Verbindung bietet ein Steg 6. Das Ende 7 des Steckers 6 bleibt mit dem Flachstecker 1 zunächst verbunden und ist als Rastklinke ausgebildet. Das freie Ende 8 des Steckers 6 bildet eine Rastnase.

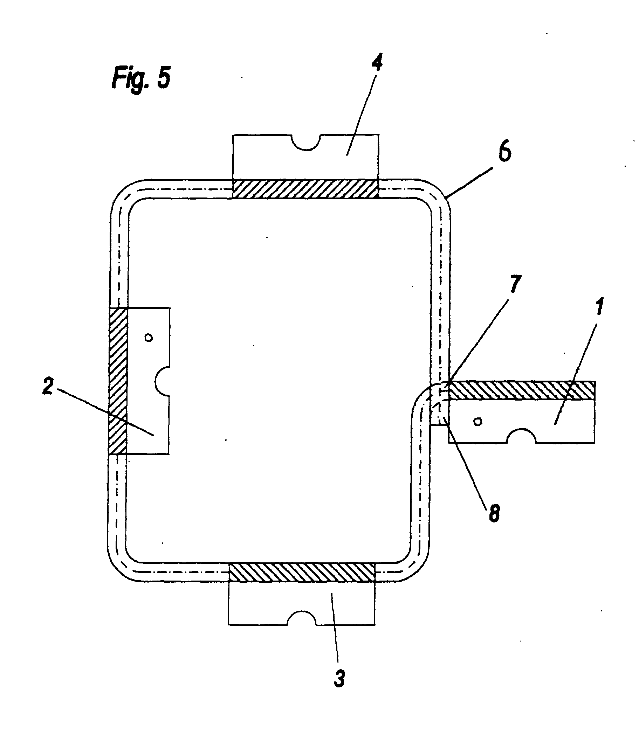

Aus Fig. 5 ist ersichtlich, wie der Steg 6 beim Lötvorgang ein umfangsgeschlossenes Band um die Stecker 1 - 4 bildet, da seine Enden 7, 8 miteinander verbunden sind, was im Fall der Randleiste 5 nicht möglich ist, da der Flachstecker 1 rechtwinkelig zum Flachstecker 2 verläuft (vgl. Fig. 1 und 2). Selbstverständlich muß auch der Steg 6 nach dem Verlöten der Flachstecker 1 - 4 mit der Unterlage 9 zumindest so weit entfernt werden, daß die elektrische Verbindung unter den Flachsteckern 1 - 4 unterbrochen ist. Dieses Entfernen erfolgt zweckmäßigerweise in einem einheitlichen Stanzvorgang zusammen mit der Entfernung der Randleiste 5.

Gegenüber dem dargestellten Ausführungsbeispiel sind im Rahmen der Erfindung zahlreiche Abänderungen möglich.

Üblicherweise wird man die Steckkontakte in einem Endlosverfahren durch Stanzen, Laser- oder Wasserstrahl aus einem Blechband herstellen. Zahl und Abstand der Steckkontakte kann dabei jederzeit dem gewünschten Anwendungszweck angepaßt werden. Insbesondere ist die Form der Steckkontakte nicht auf die dargestellten Flachstecker beschränkt: ein rechteckiger Querschnitt der Kontaktstifte wäre genauso gut realisierbar.

## Patentansprüche

1. Verfahren zur Herstellung eines mehrere zu einer Unterlage (9) rechtwinkelig abstehende, auf diese Unterlage aufgelötete Steckkontakte (1-4) aufweisenden elektrischen Bauelementes (10), insbesondere eines auf einer Keramikplatte angeordneten Halbleiterelementes, wobei die Steckkontakte zunächst einseitig durch eine Randleiste (5) des Blechbandes verbunden bleiben, aus dem sie hergestellt werden, bis die Lötverbindung mit der Unterlage hergestellt ist, woraufhin die Randleiste entfernt wird, **dadurch gekennzeichnet, daß** die Steckkontakte am Bleckband untereinander parallel sind, und deren endgültige, relative Position durch Verbiegen des Blechbandes um eine zu den Steckkontakten parallele Achse festgelegt wird.

2. Verfahren nach Anspruch 1, **dadurch gekennzeichnet, daß** die Steckkontakte (1-4) bis nach Beendigung des Lötvorganges zusätzlich durch einen mit Abstand von ihren abgewinkelten Enden verlaufenden Steg (6) verbunden bleiben, welcher zusammen mit den Steckkontakten (1-4) hergestellt ist, wobei zunächst die Enden des Steges (6) durch eine Rastverbindung (7,8) miteinander verbunden werden.

3. Verfahren nach Anspruch 1 oder 2, **dadurch gekennzeichnet, daß** die Steckkontakte (1-4) im Endlosverfahren durch Stanzen, Laser- oder Wasserstrahl aus dem Blechband hergestellt werden.

4. Verfahren nach einem der Ansprüche 2 oder 3, **dadurch gekennzeichnet, daß** die Randleiste (5) und der Steg (6) in einem gemeinsamen Stanzvorgang entfernt werden.

5. Verfahren nach Anspruch 4, **dadurch gekennzeichnet, daß** der Steg (6) zwischen den einzelnen Steckkontakten nur über einen Teil seiner Länge abgetrennt wird.

6. Verfahren nach einem der Ansprüche 1 bis 5, **dadurch gekennzeichnet, daß** der Querschnitt der Steckkontakte (1-4) rechteckig oder quadratisch ist.

7. Verfahren nach einem der Ansprüche 1 bis 6, **dadurch gekennzeichnet, daß** einer oder mehrere der Steckkontakte (4) Justierfahnen (11) aufweisen, welche in Löcher der Unterlage (9) einsteckbar sind.

## Claims

1. A process for the production of an electrical component (10) having a plurality of plug contacts (1-4) projecting at a right angle in relation to a substrate (9) and which are soldered on to said substrate, in particular a semiconductor element arranged on a ceramic plate, wherein the plug contacts initially remain connected at one side by an edge bar portion (5) of the sheet metal strip from which they are produced until the solder connection to the substrate is made, whereupon the edge bar portion is removed, **characterised in that** the plug contacts on the sheet metal strip are mutually parallel and their definitive relative position is established by bending the sheet metal strip about an axis parallel to the plug contacts.

2. A process according to claim 1 **characterised in that** the plug contacts (1-4) additionally remain connected until after termination of the soldering procedure by a limb (8) which extends at a spacing from the angled ends thereof and which is produced together with the plug contacts (1-4), wherein initially the ends of the limb (6) remain connected together by a retaining connection (7, 8).

3. A process according to claim 1 or claim 2 **characterised in that** the plug contacts (1-4) are produced in an endless process by stamping, laser beam or water jet from the sheet metal strip.

4. A process according to one of claims 2 and 3 **characterised in that** the edge bar portion (5) and the limb (6) are removed in a common stamping operation.

5. A process according to claim 4 **characterised in that** the limb (6) is cut off between the individual plug contacts only over a part of its length.

6. A process according to one of claims 1 to 5 **characterised in that** the cross-section of the plug contacts (1-4) is rectangular or square.

7. A process according to one of claims 1 to 6 **characterised in that** one or more of the plug contacts (4) have adjusting lugs which can be inserted into holes in the substrate (9).

## Revendications

1. Procédé de fabrication d'un composant électrique (10) comportant plusieurs contacts à fiches (1 à 4) disposés à distance, perpendiculairement à un support (9) et brasés sur ce même support, et plus particulièrement d'un composant semi-conducteur disposé sur une plaque céramique, les contacts à fiches restant dans un premier temps reliés unilatéralement par une lisière (5) de la bande de tôle, à partir de laquelle ils sont fabriqués, et ce jusqu'à ce que la connexion soudée sur le support soit réalisée, à la suite de quoi la lisière est retirée, **caractérisé en ce que** les contacts à fiches sont parallèles les uns par rapport aux autres au niveau de la bande de tôle et que leur position relative finale est fixée par la torsion de la bande de tôle autour d'un axe parallèle aux contacts à fiches.

2. Procédé selon la revendication 1, **caractérisé en ce que**, jusqu'après l'achèvement du soudage, les contacts à fiches (1 à 4) restent reliés en outre par une barrette (6) passant à distance de leurs extrémités pliées en U, qui est fabriquée conjointement avec les contacts à fiches (1 à 4), les extrémités de la barrette (6) étant dans un premier temps reliées les unes aux autres par une connexion à crans (7, 8).

3. Procédé selon la revendication 1 ou 2, **caractérisé en ce que** les contacts à fiches (1 à 4) sont fabriqués à partir de la bande de tôle dans un procédé continu par découpage, rayon laser ou jet d'eau.

4. Procédé selon l'une quelconque des revendications 2 ou 3, **caractérisé en ce que** la lisière (5) et la barrette (6) sont retirées dans une procédure de découpage commune.

5. Procédé selon la revendication 4, **caractérisé en ce que** la barrette (6) est détachée entre chaque contact à fiches uniquement sur une partie de sa longueur.

6. Procédé selon l'une quelconque des revendications 1 à 5, **caractérisé en ce que** la coupe transversale des contacts à fiches (1 à 4) est rectangulaire ou carrée.

7. Procédé selon l'une quelconque des revendications 1 à 6, **caractérisé en ce qu'**un ou plusieurs des contacts à fiches (4) comportent des ergots d'ajustage (11) qui sont enfichables dans les trous du support (9).
